# EUROPEAN PATENT SPECIFICATION

(11) **EP 3 533 085 B1**
(45) Date of publication and mention of the grant of the patent: **29.07.2020**
(21) Application number: 17798337.6
(22) Date of filing: 24.10.2017
(51) Int. Cl.: H01L 27/16, H01L 35/34

(54) **INTEGRATED THERMOELECTRIC GENERATOR AND RELATED METHOD OF FABRICATION**
INTEGRIERTER THERMOELEKTRISCHER GENERATOR UND ZUGEHÖRIGES VERFAHREN ZUR HERSTELLUNG
GÉNÉRATEUR THERMOÉLECTRIQUE INTÉGRÉ ET PROCÉDÉ DE FABRICATION ASSOCIÉ

(30) Priority: 28.10.2016 IT 201600109345
(43) Date of publication of application: 04.09.2019
(73) Proprietor: Consorzio Delta Ti Research, 20124 Milano (IT)
(72) Inventor: SPAZIANI, Fabio, 67051 Avezzano (AQ) (IT); IULIANELLA, Enrico, 67057 Pescina (AQ) (IT); NARDUCCI, Dario, 20126 Milano (IT); MASCOLO, Danilo, 40135 Bologna (IT); BUOSCIOLO, Antonietta, 83031 Ariano Irpino (AV) (IT); LATESSA, Giuseppe, 00133 Roma (IT); GISON, Italo, 00015 Monterotondo (RM) (IT)
(74) Representative: Barbaro, Gaetano
(86) International application number: PCT/IB2017/056579
(87) International publication number: WO 2018/078515

(56) References cited:
- WO-A1-2016/055892
- US-A1- 2006 102 223
- US-A1- 2014 246 066
- US-B1- 6 825 057

## Description

### TECHNICAL FIELD

This disclosure relates in general to solid state thermoelectric devices, in particular to thermoelectric generators (TEGs) amenable to be fabricated with CMOS or BiCMOS technologies, and a related method of fabrication.

### BACKGROUND OF THE INVENTION

Thermoelectric generators (TEGs) are earnestly investigated as low enthalpy waste heat exploitation devices of outstanding robustness, reliability and virtually unlimited service life, besides being made of environmental friendly materials.

As power consumption of increasingly popular electronic devices is constantly minimized, TEGs begin to be considered as supplementary power source in conjunction or even in substitution of batteries or other energy storage devices like super-capacitors.

There is an increasing number of publications concerning thin film technology TEGs exploiting well established processing techniques developed in the Microelectronics and Micro-Electro-Mechanical-Systems (MEMSs), like planar processing, micromachining implant and post implant treatments, flip-chip and bonding techniques and alike.

The doctorate thesis "Silicon-Micromachined Thermoelectric Generators for Power Generation from hot gas streams" by Israel Boniche, University of Florida, 2010, and "Monolithic integration of VLS silicon nanowires into planar thermoelectric generators" by Diana Davila Pineda, Autonomous University of Barcelona, 2011, offer an extensive introductory review of state-of-the-art practices in the field of thermoelectric devices for solid state heat pumps and power generators.

The review encompasses also two families of TEGs manufactured with silicon-compatible micro- and nano-technologies: in devices of a first family heat flow is parallel and in the other family orthogonally to the substrate. The architectures of these integrated TEGs generally comprise a number of elementary cells having n-p doped legs, arranged in such a way that the elementary cells are thermally in parallel and electrically in series.

Typically, integrated TEG devices in which heat flows parallel to the substrate may have conductive legs of thermoelectrically active materials deposited over a very high thermal resistance material or a membrane, suspended several hundreds of micrometers above the substrate, or the legs of active materials themselves are free-standing [membrane-less].

Other relevant examples are reported in :
▪ Huesgen, T.; Wois, P.; Kockmann, N. Design and fabrication of MEMS thermoelectric generators with high temperature efficiency. Sens. Actuators A 2008, 145-146, 423-429.
▪ Xie, J.; Lee, C.; Feng, H. Design, fabrication and characterization of CMOS MEMS-based thermoelectric power generators. J. Micromech. Syst. 2010, 19, 317-324.
▪ Wang, Z.; Leonov, V.; Fiorini, P.; van Hoof, C. Realization of a wearable miniaturized thermoelectric generator for human body applications. Sens. Actuators A 2009, 156, 95-102.
▪ Wang, Z.; Fiorini, P.; Leonov, V.; van Hoof, C. Characterization and optimization of polycrystalline Si70%Ge30% for surface micromachined thermopiles in human body applications. J. Micromech. Microeng. 2009, doi: 10.1088/0960-1317/19/9/094011.
▪ Su, J.; Leonov, V.; Goedbloed, M.; van Andel, Y.; de Nooijer, M.C.; Elfrink, R.; Wang, Z.; Vullers, R.J. A batch process micromachined thermoelectric energy harvester: Fabrication and characterization. J. Micromech. Microeng. 2010, doi: 10.1088/0960-1317/20/10/104005.
▪ Yang, S.M.; Lee, T.; Jeng, C.A. Development of a thermoelectric energy harvester with thermal isolation cavity by standard CMOS process. Sens. Actuators A 2009, 153, 244-250.
▪ Kao, P.-H.; Shih, P.-J.; Dai, C.-L.; Liu, M.-C. Fabrication and characterization of CMOS-MEMS thermoelectric micro generators. Sensors 2010, 10, 1315-1325.
▪ Wang, Z.; van Andel, Y.; Jambunathan, M.; Leonov, V.; Elfrink, R.; Vullers, J.M. Characterization of a bulk-micromachined membraneless in-plane thermopile. J. Electron. Mater. 2011, 40, 499-503.13.
▪ Patent US 7,875,791 B1 "Method for manufacturing a thermopile on a membrane and a membrane-less thermopile, the thermopile thus obtained and a thermoelectric generator comprising such thermopiles" Vladimir Leonov, Paolo Fiorini, Chris Van Hoof (2011)
▪ Miniaturized thermopile on a membrane are also described by A. Jacquot, W.L. Liu, G. Chen, J.P. Fleurial, A. Dauscher, B. Lenoir, in "Fabrication and Modeling of an in-plane thermoelectric micro-generator", Proceedings ICT'02. 21st International Conference on Thermoelectrics, p. 561-564 (2002).

Other examples of parallel heat flow TEG structures rely on the ability of growing or defining populations of conductors (nanowires). The articles: "A. I. Hochbaum, R. K. Chen, R. D. Delgado, W. J. Liang, E. C. Garnett, M. Najarian, A. Majumdar, and P. D. Yang, Nature 451, 163-U5 (2008)" and "A. I. Boukai, Y. Bunimovich, J. Tahir-Kheli, J.-K. Yu, W. A. Goddard III, and J. R. Heath, Nature 451, 168-171 (2008)"; "F. Suriano, M. Ferri, F. Moscatelli, F. Mancarella, L. Belsito, S. Solmi, A. Roncaglia, S. Frabboni, G.C. Gazzadi, and D. Narducci, 'Influence of Grain Size on the Thermoelectric Properties of Polycrystalline Silicon Nanowires', Journal of Electronic Materials, 44 (2015) 371 (USA)" and "N. Neophytou, X. Zianni, M. Ferri, A. Roncaglia, G. F. Cerofolini, and D. Narducci, 'Nanograin effects on the thermoelectric properties of poly-Si nanowires', Journal of Electronic Materials, 42 (2013) 2393 (USA)"; WO2009/125317; EP1,083,610; WO2011/007241; WO2011/073142; offer a review of practices following such an approach.

US 7,875,791 B1 (by Leonov et al.) discloses thermopiles that may be supported by a membrane layer or that may be self-supporting. Despite the apparent easy manufacturability of these devices, heat is forced to move in a complicated structure with significant thermal losses. In addition, in some cases adhesive are needed in order to assure thermal contact to a heat source at the top or the bottom surface of the initial substrate. This results in poor thermal coupling at system level, lossy thermal paths and mechanical fragilities, all features that penalize performance of the thermopile.

A second family of TEG devices is often referred to as "out-of-plane" heat flux TEGs. They are characterized by the fact that heat flows orthogonally to the substrate. In these devices the thermoelectrically active materials are usually laid on or are part of high aspect-ratio supporting structures standing onto the substrate. Despite a more sophisticated and apparently expensive fabrication process, this configuration minimizes thermal losses, simplifies thermal coupling at system level enhancing overall performance.

The "out-of-plane" heat flux TEGs are amenable to miniaturization and integration in microelectronic and optoelectronic devices, among other applications. Examples are reported by M. Strasser et al. in "Miniaturized Thermoelectric Generators Based on Poly-Si and Poly-SiGe Surface Micromachining", (presented in The 11th International Conference on Solid-State Sensors and Actuators, Munich, Germany, June 10-14, 2001) and "Micromachined CMOS Thermoelectric Generators as On-Chip Power Supply" (presented in The 12th International Conference on Solid-State Sensors and Actuators and Microsystems, Boston, USA, June 8-12, 2003). Out-of-plane or orthogonal heat flux thin film structures are useful for innumerable applications, for example for micro power generation or for temperature management in complex integrated systems, for energy recovery or harvesting.

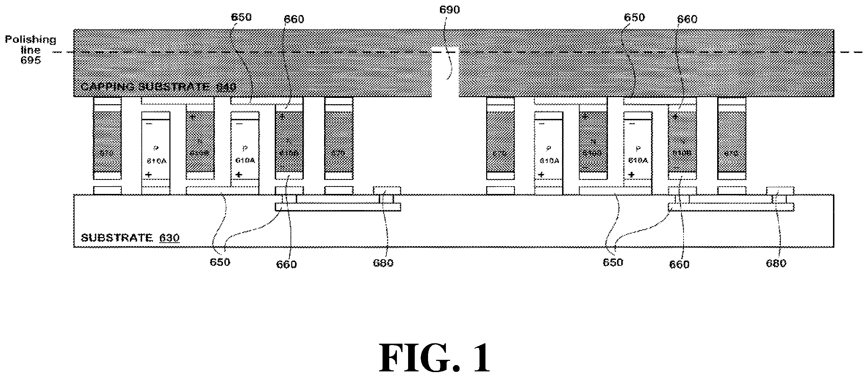

US2014/0246066 (Chen et al.), upon the teaching of which the preamble of claim 8 is drafted, discloses a thermoelectric energy harvester, shown in figure 1, having a plurality of P-type and N-type thermoelectric elements connected in series. The thermoelectric energy harvester may be formed with separated thermoelectric elements 610A, 610B realized on two different substrates 630 and 640 that may be mounted together.

The document WO2016/055892, upon the teaching of which the preamble of claim 1 is drafted, discloses an integrated thermoelectric generator comprising a dielectric base layer over which spaced hills of a relatively low thermal conductivity material are defined. Juxtaposed segments, alternately p-doped and n-doped, of defined thin film lines of segments of a polycrystalline semiconductor, extend over inclined opposite flanks of the hills for converting in electricity part of the heat flowing in a direction orthogonal to the generator. Hill-top contacts and valley-bottom contacts join juxtaposed ends of the p-doped and n-doped segments. A second wafer made of silicon crystal, provided with a thin dielectric layer formed over a surface of the silicon crystal to render it electrically non conductive, is defined so as to have metal pads defined over the thin dielectric layer. The second wafer is bonded over the hill-top contacts to as to bring the metal pads of the second wafer in direct contact with the hill-top contacts. The void spaces between the hills of low thermal conductivity material are sealed by the thin layer of dielectric material, which is solid and has no holes. Spaced parallel silicon vias holes are formed through the silicon crystal of the second wafer in geometrical projection correspondence with the hill-top or valley-bottom contacts, and terminate against the solid thin dielectric layer. The thin layer that seals the void spaces does not have any hole so as to close from atop the cavities of the generator and to close from the bottom the parallel silicon vias holes formed through the silicon crystal. As stated before, the integrated thermoelectric generator disclosed in the document WO2016/055892 is realized with a flip-chip bonding technique.

The document US 6,825,057 discloses a process for manufacturing a membrane sensor over a silicon substrate. A sacrificial layer is deposited in a conformal manner over a concave surface of a silicon substrate to fill the concavity, and a thin membrane layer of silicon carbide or of silicon nitride is deposited over the silicon substrate and over the sacrificial layer. Through holes are defined throughout the thin membrane layer and the sacrificial layer is fully etched by means of an etching solution poured throughout the through holes, letting the thin layer membrane remain suspended over the concave cavity.

The membrane may be coated with a protection layer of silicon nitride or silicon carbide, in order to protect against dirt the free surface of the membrane oriented outwards, provided that this protection layer is thinner than the membrane and that the protection layer leaves open the through holes.

Electric power yield from a given heat flow and electric power yield versus the footprint area of out-of-plane or orthogonal heat flux devices of the prior art, based on a common semiconductor or any material compatible with ICs fabrication processes, has to be enhanced. There is a need of more efficient and compact TEG that could be realized by means of a process fully compatible with standard CMOS or BiCMOS technologies.

### SUMMARY

As in known devices, the generator of this disclosure has hill-top junction metal contacts and valley-bottom junction metal contacts joining juxtaposed ends of segments alternately p-doped and n-doped defined over inclined opposite flanks of hills and valleys of a dielectric material, useful for converting in electricity part of the heat flowing in a direction orthogonal to the planar generator, and a planar electrically non conductive cover layer laying onto the hill-top junction metal contacts and suspended above the valleys, that are void spaces delimited at the top by the non conductive cover layer.

The present applicant has found an integrated thermoelectric generator of out-of-plane heat flux configuration that can be fabricated with a process fully compatible with standard front-end CMOS or BiCMOS technologies. According to this disclosure, portions of the planar electrically non conductive cover layer above over the valleys have sufficiently large through holes to let isotropic etching solutions or etching plasma pass therethrough, across the thickness of the electrically non conductive cover layer (9), so as to realize void spaces by etching a sacrificial layer. The generator further comprises a top capping layer (11) deposited onto a free surface, oriented in an opposite direction in respect to the void spaces, of said planar electrically non conductive cover layer (9) so as to occlude the through holes (10) of the electrically non conductive cover layer (9).

A method of fabricating an integrated thermoelectric generator of out-of-plane heat flux configuration is also disclosed.

### BRIEF DESCRIPTION OF THE DRAWINGS

Figure 1 depicts a prior thermoelectric energy harvester.
Figures 2 to 11 illustrate in succession the steps of a process of fabrication of a cell of an integrated thermoelectric generator according to this disclosure.

### DETAILED DESCRIPTION

Figures from 2 to 11 illustrate the fabrication steps of a single cell of a thermoelectric generator of this disclosure. The depicted structure may be replicated identically over a silicon wafer to realize an integrated thermoelectric generator with a fabrication process fully compatible with CMOS and BiCMOS technologies.

With reference to figures from 2 to 11, a bottom substrate 1, that may be a silicon wafer, is used for fabricating thereon the integrated TEG of out-of-plane (orthogonal) heat flux type. Commercially available silicon wafers of any size may be used.

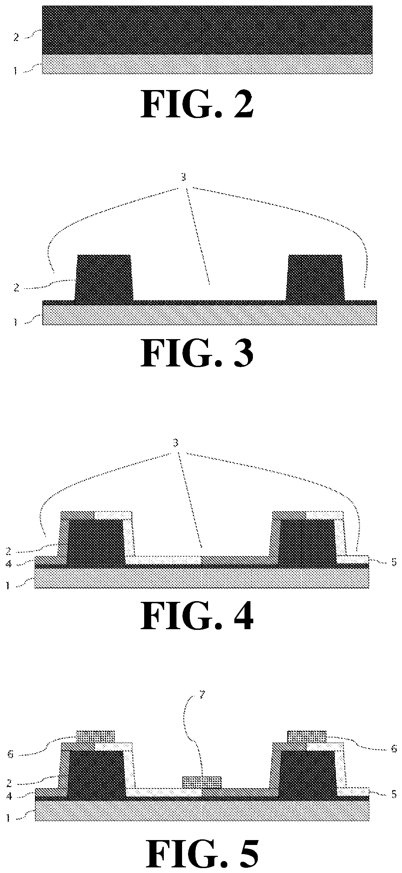

A dielectric base layer 2 of substantially uniform thickness (Fig. 2), that for example may be made of silicon dioxide, is grown or deposited by thermal oxidation or PECVD deposition on the bottom substrate 1. By means of well established techniques, the dielectric base layer 2 is shaped in order to have an uneven thickness to define hills, in correspondence of thicker portions, spaced by valleys 3, in correspondence of thinner portions of the dielectric layer 2.

The dielectric base layer 2 has a minimum thickness in correspondence of the valleys 3 sufficient to provide a necessary bottom electrical insulation without introducing a significant thermal resistance. The height of the spaced hills generally may be comprised between 0,1 and 50 µm. The typical inclined flanks of hills define valleys 3 therebetween, the substantially planar bottom of which generally may have a width comprised between 0,1 and 100 µm, most preferably between 0.2 and 50 µm, similarly to the width of the top of the hills. The hills may be defined through a succession of masking and etching steps in order to slant the walls of the progressively etched valleys 3 toward a substantially flat bottom by an angle of inclination from the base plane that preferably is comprised between 45 and 85 degrees.

Thin film segments 4 and 5 of thermoelectric (TE) materials are deposited over the hills and valleys 3 defined by the dielectric base layer 2. According to an embodiment, the thin film segments 4 and 5 are made of p-doped and n-doped polycrystalline semiconductor material such as, for example, doped Si or SiGe. The segments 4 and 5, deposited in form of a thin film of substantially uniform thickness over the bottom dielectric 2 and the spaced hills, constitute the two legs of thermoelectric material that electrically connect a junction at the valley bottom to the two adjacent junctions on top of the hills. In order to have a thermoelectric effect, the thin film segments may be deposited side to side to form junctions of different thermoelectric materials, as shown in figure 4, or, according to an alternative not shown in the enclosed figures, there may be a gap filled with metal between adjacent segments 4 and 5.

The hills material should have a low thermal conductivity, significantly lower than the thermal conductivity of the material of the p-type and n-type segments of conductive material supported thereon, in order to further penalize by-pass paths of heat conduction flow alternative to the paths of productive heat conduction along the polycrystalline doped semiconductor thin film segments or legs defined over opposite slanted surfaces of the truncated rectangular pyramid shaped hills or of hills with a trapezoidal cross section along one axis and straight sides or flanks orthogonal to it.

Examples of suitable materials of lower thermal conductivity than the thermal conductivity of a thermoelectrically active polycrystalline semiconductor and their respective heat conduction coefficients are reported in the following table.

| Material | Thickness[nm] | Thermal Conductivity [W m⁻¹ K⁻¹ ] |
|---|---|---|
| Thermal SiO2 | > 250 | ∼1.2 |
| SiO2 (PECVD@300C) | 30 -50 | 0.82 ± 0.02 |
| SiO2 (PECVD@300C) | 90 -180 | 1.00 ± 0.10 |
| SiO2 (PECVD@300C) | >200 | ∼1.2 (Bulk) |
| SiNx (PECVD@300C) | 20 -40 | 0.55 ± 0.05 |
| SiNx (PECVD@300C) | 60 -120 | 0.65 ± 0.05 |
| SiNx (APCVD@900C) | 180 | ∼1.45 |

The deposited doped polycrystalline silicon layer of the segments 4 and 5 may have thickness, generally comprised between 10 and 1000 nm, but may even be as thick as one or more micrometers, depending on contemplated applications, scaling of the elementary cell structure, properties of the polycrystalline semiconductor material used and design choices of the integrated TEG. The cold and hot junctions, respectively at valley bottoms and at hill-tops or vice versa, are both constituted by metal contacts of low aspect ratio, respectively 6 and 7, electrically connecting the ends of adjacent p-doped segments 5 and of n-doped segments 4. The metal contacts 6 and 7 may be made, for example, of an Aluminum-Silicon alloy.

Differently from what is commonly hold true in the art, it is not mandatory to have adjacent p-doped segments 5 and of n-doped segments 4 separated by a gap filled with metal for avoiding formation of p-n junctions. The present applicant noticed that the metal contacts 6 and 7, that must be realized for acting as hot and cold electrodes of the thermoelectric generator, are large enough to short-circuit the p-n junctions covering the whole depletion region, thus the junctions do not hinder current flow through the generator. Defining thermoelectric segments side by side may be convenient because the performances of the generator are not worsened, though the fabrication process is relevantly simplified because it is not necessary an additional masking step for defining the gaps (to be filled with metal) between the segments 4 and 5.

The deposited metal layer of the junction metal contacts 6 and 7 that extend over and in electrical contact with the end portions of the two segments 4 and 5 of polycrystalline semiconductor, may have a thickness ranging from about 0.1 to about 5 µm.

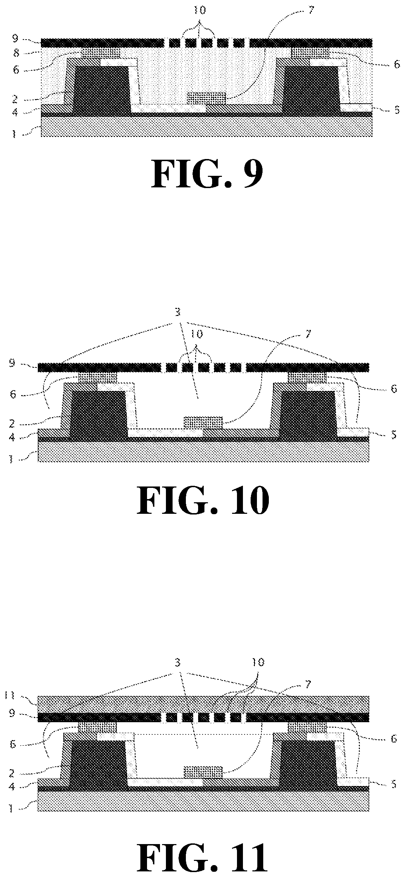

In order to increase thermal isolation among hill-top metal contacts 6, that will constitute either the hot or cold electrodes of the thermal generator, and valley-bottom metal contacts 7, that will constitute either the cold or hot electrodes, it is highly beneficial to seal the void valleys under vacuum. In order to close the void valleys 3 between the hills with a capping layer 11 (figure 11), that may be a solid layer, using a fabrication process fully compatible with a front-end CMOS or BiCMOS fabrication technology, the steps illustrated in figures from 6 to 11 are performed.

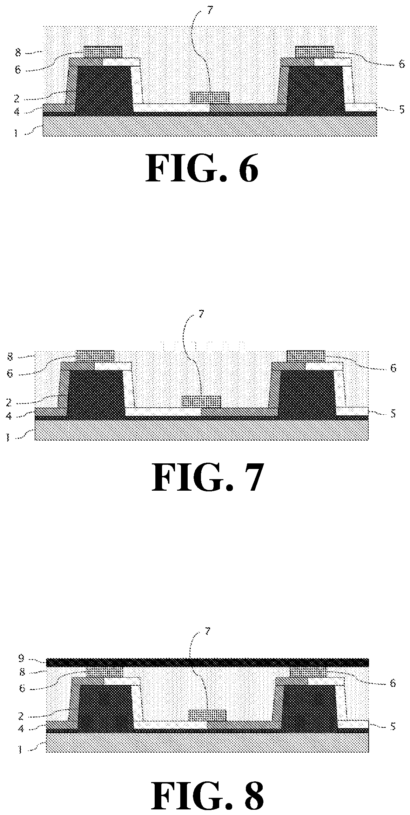

A layer 8 of sacrificial material (figure 6), adapted to be isotropically etched with wet etching solutions or with an etching plasma, is deposited onto the structure of figure 5 so as to fill the valleys 3 and to bury the metal contacts 6 and 7 and the segments 4 and 5. This sacrificial material may be Silicon dioxide or a Carbon Based Material, deposited for example at a low temperature. The sacrificial layer 8 is then planarized (figure 7) so as to uncover an upper surface of the hill-top metal contacts 6, for example with a Chemical Mechanical Polishing (CMP) technique or with an etch back technique or with a combination of the two.

An electrically non-conductive cover layer 9 is deposited (figure 8) onto the planarized free surface of the sacrificial layer 8 and onto the upper surfaces of the hill-top metal contacts 6. For example, the cover layer 9 may be made of Silicon nitride or Silicon dioxide deposited using a conventional low temperature PECVD technique. Then portions of the electrically non conductive cover layer 9 are pierced in correspondence of the valleys so as to define holes 10 (figure 9) through its thickness, for example with standard photolithographic and dry etch steps. The through holes 10 are sufficiently large to let isotropic etching solutions or etching plasma pass therethrough and are placed and shaped so as to efficiently remove the sacrificial layer 8 (figure 10) with either a wet etching process, for example by flowing Hydrofluoric Acid vapor, or a dry etch process, for example using Oxygen plasma.

Merely as an example, the through holes 10 may have a diameter defined so as to be wide enough to let the etching solutions of the etching plasma pass therethrough and to be narrow enough to be closed by deposition of a capping layer 11 without letting the material of the capping layer drop into the void spaces.

Merely as an example, the holes may have a diameter not greater than 500 nm. The minimum size of the diameter may be determined in accordance with the process used for removing the sacrificial layer and in accordance with a maximum time fixed for removing the sacrificial layer. In order to securely occlude the holes, the thickness of the capping layer 11 may be at least equal to or greater than, for example by two or three times, the diameter of the through holes 10.

When the whole sacrificial layer has been removed, portions of the cover layer 9 are suspended above the void spaces in correspondence of the valleys 3.

Finally, a top capping layer 11 is deposited (figure 11), for example with a sputtering process, over the nonconductive layer 9 so as to occlude the through holes 10 of the non conductive cover layer 9. Numerous materials may be used for this last step: preferably, a metal like Aluminum can be used for realizing a top capping layer 11 with both good electrical and thermal coupling.

Preferably, the bottom substrate 1 and the top capping layer 11, that will be placed in contact either with a hot or with a cold heat source, respectively, are subjected to a thinning process, after device manufacturing, aiming to reduce heat losses between the substrate 1 or layer 11 and the junctions of thermoelectric segments 4 and 5. According to an embodiment, the thicknesses of the bottom substrate 1 and of the top capping layer 11 range respectively between 0.5 to 2.0 microns and 0.1 to 2 microns.

The void spaces in correspondence of the valleys 3 are permanently sealed during packaging or back-end operations by occluding side gaps between the bottom substrate 1 and the non conductive cover layer 9, and are evacuated upon packaging.

The cell shown in figure 11 can be identically replicated numerous times over a silicon wafer and the corresponding hot and cold electrodes 6 and 7 can be electrically and thermally connected together to form hot and cold electrodes of a multi-cell thermoelectric generator.

The thermoelectric generator of this disclosure has the following advantages:
- it can be fabricated with a CMOS or BiCMOS fully compatible process without using any bonding technique, such as flip chip or wafer to wafer technique;
- there is no risk of misalignment nor is necessary to use resins, as in bonding techniques, that would increase thermal losses and thus would reduce the overall efficiency of the thermoelectric generator;
- vacuum inside the cavities/spaces allows to minimize heat losses.

## Claims

1. An integrated thermoelectric generator of out-of-plane heat flux configuration, said generator comprising:
a bottom substrate (1);
a dielectric layer (2) deposited onto a face of said bottom substrate (1) with uneven thickness, in order to define hills and valleys of dielectric material;
juxtaposed segments (4, 5), alternately p-doped and n-doped, of defined thin film lines of segments of a polycrystalline semiconductor, extending over inclined opposite flanks of said hills, useful for converting in electricity part of the heat flowing in a direction orthogonal to the generator,
hill-top junction metal contacts (6) and valley-bottom junction metal contacts (7) joining juxtaposed ends of said segments (4, 5) alternately p-doped and n-doped,
a planar electrically non conductive cover layer (9) laying onto said hill-top junction metal contacts and suspended above said valleys, all valleys among said hills (3) being void spaces delimited at the top by the non conductive cover layer (9),
**characterized in that**
portions of said planar electrically non conductive cover layer (9) suspended over each valley of said valleys have through holes (10), said through holes (10) communicating with said void spaces and being sufficiently large to let isotropic etching solutions or etching plasma pass therethrough across the thickness of the electrically non conductive cover layer (9);
said generator further comprises a top capping layer (11) deposited onto a free surface, oriented in an opposite direction in respect to said void spaces, of said planar electrically non conductive cover layer (9) so as to occlude the through holes (10) of the electrically non conductive cover layer (9).

2. The thermoelectric generator of claim 1, wherein said void spaces are permanently sealed by occluding side gaps between the bottom substrate (1) and said electrically non conductive cover layer (9).

3. The thermoelectric generator of claim 1 or 2, wherein said void spaces are evacuated.

4. The thermoelectric generator of one of claims from 1 to 3, wherein said p-doped and n-doped segments (4, 5) are joined together in an alternated fashion to form p-n junctions, each of said hill-top junction metal contacts (6) and valley-bottom junction metal contacts (7) being disposed to short-circuit a respective one of said p-n junctions.

5. The thermoelectric generator of one of claims from 1 to 4, wherein said topmost capping layer (11) is a metal layer.

6. The thermoelectric generator of claim 1, wherein said n-doped and p-doped thin film segments (4, 5) are made of polycrystalline silicon.

7. The thermoelectric generator of claim 1, wherein said hills (3) are regularly spaced and have a truncated rectangular pyramid shape or a trapezoidal cross section along one axis and straight sides or flanks orthogonal to it.

8. A method of fabricating an integrated thermoelectric generator of out-of-plane heat flux configuration, comprising the following steps:
depositing a dielectric layer (2) with uneven thickness onto a face of a bottom substrate (1) in order to define hills and valleys of dielectric material,
depositing juxtaposed segments (4, 5), alternately p-doped and n-doped, of defined thin film lines of segments of a polycrystalline semiconductor extending over inclined opposite flanks of said hills,
depositing hill-top junction metal contacts (6) and valley-bottom junction metal contacts (7) joining juxtaposed ends of said segments (4, 5) alternately p-doped and n-doped,
depositing a layer of sacrificial material (8) in order to fill said valleys and to cover said juxtaposed segments (4, 5), leaving uncovered only upper surfaces of said hill-top junction metal contacts (6),
depositing a planar electrically non conductive cover layer (9) laying onto said hill-top junction metal contacts,
**characterized in that** the method is fully compatible with a front-end CMOS or BiCMOS fabrication technology, and further comprises the steps of:
realizing sufficiently large through holes (10) to let isotropic etching solutions or etching plasma pass therethrough, across the thickness of the electrically non conductive cover layer (9);
removing said sacrificial material (8) by injecting an isotropic etching solution or an etching plasma throughout said through holes (10), in order to make the planar electrically non conductive cover layer (9) lay onto said hill-top junction metal contacts and be suspended above said valleys, all valleys among said hills (3) being void spaces delimited at the top by the electrically non conductive cover layer (9), said through holes (10) communicating with said void spaces;
depositing a top capping layer (11) onto a free surface, oriented in an opposite direction in respect to said void spaces, of said planar electrically non conductive cover layer (9) so as to occlude the through holes (10) of the electrically non conductive cover layer (9).

9. The method of claim 8, further comprising the steps of:
evacuating said void spaces upon packaging;
sealing permanently said void spaces during packaging or back-end operations by occluding side gaps between the bottom substrate (1) and said electrically non conductive cover layer (9).

## Patentansprüche

1. Ein integrierter thermoelektrischer Generator mit einer Konfiguration für einen Wärmefluss außerhalb der Ebene, wobei der besagte Generator umfasst:
- ein unteres Substrat (1);
- eine dielektrische Schicht (2), die auf einer Seite des besagten unteren Substrats (1) mit einer ungleichmäßigen Dicke abgeschieden ist, um Erhebungen und Täler des dielektrischen Materials abzugrenzen;
- nebeneinander liegende Segmente (4, 5), abwechselnd p-dotiert und n-dotiert, von abgegrenzten, linienförmigen Dünnschicht-Sgementen eines polykristallinen Halbleiters, welche sich über einander gegenüber liegende, geneigte Flanken der besagten Erhebungen erstrecken, und welche dazu dienen, einen Teil der Wärme, die in einer Richtung orthogonal zu dem Generator fließt, in Elektrizität umzuwandeln,
- metallische Verbindungskontakte (6) auf den Kuppen der Erhebungen sowie metallische Verbindungskontakte (7) am Grund der Täler, welche nebeneinander liegende Enden der besagten, abwechselnd p-dotierten und n-dotierten Segmente (4, 5) verbinden,
- eine ebene, elektrisch nicht leitende Deckschicht (9), die auf den besagten metallischen Verbindungskontakten (6) auf den Kuppen der Erhebungen liegt und die besagten Täler überspannt, wobei alle Täler inmitten der besagten Erhebungen (3) Porenvolumina darstellen, welche an ihrer Oberseite durch die nicht leitende Deckschicht (9) begrenzt werden,
**dadurch gekennzeichnet, dass**
- Bereiche der besagten ebenen, elektrisch nicht leitenden Deckschicht (9), welche jedes Tal der besagten Täler überspannen, Durchgangslöcher (10) aufweisen, wobei die besagten Durchgangslöcher (10) mit den besagten Porenvolumina kommunizieren und ausreichend groß bemessen sind, um isotrope Ätzlösungen oder ein Ätzplasma hindurch strömen zu lassen, durch die Dicke der elektrisch nicht leitenden Deckschicht (9);
- wobei der besagte Generator ferner eine oberste Abdeckschicht (11) umfasst, die auf einer freien, den Porenvolumina abgewandten Oberfläche der besagten ebenen, elektrisch nicht leitenden Deckschicht (9) abgeschieden ist, um die Durchgangslöcher (10) der elektrisch nicht leitenden Deckschicht (9) zu verschließen.

2. Der thermoelektrische Generator nach Anspruch 1, wobei die besagten Porenvolumina permanent abgedichtet sind durch Verschließen seitlicher Spalte zwischen dem unteren Substrat (1) und der besagten, elektrisch nicht leitenden Deckschicht (9).

3. Der thermoelektrische Generator nach Anspruch 1 oder 2, wobei die besagten Porenvolumina evakuiert sind.

4. Der thermoelektrische Generator nach einem der Ansprüche 1 bis 3, wobei die besagten p-dotierten und n-dotierten Segmente (4, 5) in abwechselnder Weise miteinander verbunden sind, um p-n-Übergänge zu bilden, wobei jeder der besagten metallischen Verbindungskontakte (6) auf den Kuppen der Erhebungen und der metallischen Verbindungskontakte (7) am Grund der Täler derart angeordnet ist, dass er je einen der besagten p-n-Übergänge kurzschließt.

5. Der thermoelektrische Generator nach einem der Ansprüche 1 bis 4, wobei die besagte oberste Abdeckschicht (11) eine Metallschicht ist.

6. Der thermoelektrische Generator nach Anspruch 1, wobei die besagten n-dotierten und p-dotierten Dünnschichtsegmente (4, 5) aus polykristallinem Silizium hergestellt sind.

7. Der thermoelektrische Generator nach Anspruch 1, wobei die besagten Erhebungen (3) gleichmäßig beabstandet sind und die Gestalt eines rechteckigen Pyramidenstumpfs aufweisen oder einen trapezförmigen Querschnitt entlang einer Achse und gerade Seiten oder Flanken orthogonal dazu.

8. Ein Verfahren zur Herstellung eines integrierten thermoelektrischen Generators mit einer Konfiguration für einen Wärmefluss außerhalb der Ebene, umfassend die folgenden Schritte:
- Abscheiden einer dielektrischen Schicht (2) mit ungleichmäßiger Dicke auf einer Seite eines unteren Substrats (1), um Erhebungen und Täler des dielektrischen Materials abzugrenzen,
- Abscheiden nebeneinander liegender Segmente (4, 5), abwechselnd p-dotiert und n-dotiert, von abgegrenzten linienförmigen Dünnschicht-Segmenten eines polykristallinen Halbleiters, welche sich über einander gegenüber liegende, geneigte Flanken der besagten Erhebungen erstrecken,
- Abscheiden metallischer Verbindungskontakte (6) auf den Kuppen der Erhebungen sowie metallischer Verbindungskontakte (7) am Grund der Täler, welche nebeneinander liegende Enden der besagten, abwechselnd p-dotierten und n-dotierten Segmente (4, 5) verbinden,
- Abscheiden einer Schicht eines Opfermaterials (8), um die besagten Täler zu füllen und nebeneinander liegenden Segmente (4, 5) zu bedecken, wobei nur erhabene Oberflächen der besagten metallischen Verbindungskontakte (6) auf den Kuppen der Erhebungen unbedeckt bleiben,
- Abscheiden einer ebenen, elektrisch nicht leitenden Deckschicht (9), die über den besagten metallischen Verbindungskontakten auf den Kuppen der Erhebungen liegt,
**dadurch gekennzeichnet, dass** das Verfahren vollständig kompatibel ist mit einer CMOS- oder BICMOS-Herstellungstechnologie am vorderen Ende der Produktionslinie, und ferner die folgenden Schritte umfasst:
- Vorsehen ausreichend großer Durchgangslöcher (10), um isotrope Ätzlösungen oder ein Ätzplasma hindurch strömen zu lassen, durch die Dicke der elektrisch nicht leitenden Deckschicht (9);
- Entfernen des besagten Opfermaterials (8) durch Injizieren einer isotropen Ätzlösung oder eines Ätzplasmas durch die besagten Durchgangslöcher (10), damit die ebene, elektrisch nicht leitende Deckschicht (9) auf den besagten metallischen Verbindungskontakten (6) auf den Kuppen der Erhebungen aufliegt und die besagten Täler überspannt, wobei alle Täler inmitten der besagten Erhebungen (3) Porenvolumina darstellen, welche an ihrer Oberseite durch die elektrisch nicht leitende Deckschicht (9) begrenzt werden, und wobei die besagten Durchgangslöcher (10) mit den besagten Porenvolumina kommunizieren;
- Abscheiden einer obersten Abdeckschicht (11) auf einer freien, den Porenvolumina abgewandten Oberfläche der besagten ebenen, elektrisch nicht leitenden Deckschicht (9), um die Durchgangslöcher (10) der elektrisch nicht leitenden Deckschicht (9) zu verschließen.

9. Das Verfahren nach Anspruch 8, ferner umfassend die folgenden Schritte:
- Evakuieren der besagten Porenvolumina beim Verpacken,
- permanentes Versiegeln der besagten Porenvolumina während dem Verpacken oder während Handlungen am rückwärtigen Ende der Produktionslinie durch Verschließen seitlicher Spalte zwischen dem unteren Substrat (1) und der besagten elektrisch nicht leitenden Deckschicht (9).

## Revendications

1. Générateur thermoélectrique intégré à configuration de flux de chaleur hors plan, ledit générateur comprenant :
un substrat de fond (1) ;
une couche diélectrique (2) déposée sur une face dudit substrat de fond (1) avec une épaisseur irrégulière, afin de définir des collines et des vallées de matériau diélectrique ;
des segments juxtaposés (4, 5), dopés p et dopés n en alternance, de lignes de couches minces définies de segments d'un semi-conducteur polycristallin, s'étendant sur des flancs opposés inclinés desdites collines, utiles pour convertir en électricité une fraction de la chaleur circulant dans une direction orthogonale au générateur,
des contacts métalliques de jonction de sommet de colline (6) et des contacts métalliques de jonction de fond de vallée (7) joignant des extrémités juxtaposées desdits segments (4, 5) dopés p et dopés n en alternance,
une couche de recouvrement plane électriquement non conductrice (9) reposant sur lesdits contacts métalliques de jonction de sommet de colline et suspendue au-dessus desdites vallées, toutes les vallées entre lesdites collines (3) étant des espaces vides délimités au sommet par la couche de recouvrement non conductrice (9),
**caractérisé en ce que**
des parties de ladite couche de recouvrement plane électriquement non conductrice (9) suspendues au-dessus de chaque vallée desdites vallées possèdent des trous traversants (10), lesdits trous traversants (10) communiquant avec lesdits espaces vides et étant suffisamment grands pour laisser des solutions de gravure isotrope ou un plasma de gravure passer à travers ceux-ci sur toute l'épaisseur de la couche de recouvrement électriquement non conductrice (9) ;
ledit générateur comprend en outre une couche de coiffage supérieure (11) déposée sur une surface libre, orientée dans une direction opposée par rapport auxdits espaces vides, de ladite couche de recouvrement plane électriquement non conductrice (9) de façon à obstruer les trous traversants (10) de la couche de recouvrement électriquement non conductrice (9).

2. Générateur thermoélectrique selon la revendication 1, dans lequel lesdits espaces vides sont scellés de façon permanente par l'obstruction d'intervalles latéraux entre le substrat de fond (1) et ladite couche de recouvrement électriquement non conductrice (9).

3. Générateur thermoélectrique selon la revendication 1 ou 2, dans lequel lesdits espaces vides sont évacués.

4. Générateur thermoélectrique selon l'une des revendications 1 à 3, dans lequel lesdits segments dopés p et dopés n (4, 5) sont joints ensemble d'une manière alternée pour former des jonctions p-n, chacun desdits contacts métalliques de jonction de sommet de colline (6) et contacts métalliques de jonction de fond de vallée (7) étant disposés pour court-circuiter l'une respective desdites jonctions p-n.

5. Générateur thermoélectrique selon l'une des revendications 1 à 4, dans lequel ladite couche de coiffage la plus supérieure (11) est une couche métallique.

6. Générateur thermoélectrique selon la revendication 1, dans lequel lesdits segments de couche mince dopés n et dopés p (4, 5) sont constitués de silicium polycristallin.

7. Générateur thermoélectrique selon la revendication 1, dans lequel lesdites collines (3) sont espacées de manière régulière et possèdent une forme de pyramide rectangulaire tronquée ou une section transversale trapézoïdale le long d'un axe et des côtés ou flancs droits orthogonaux à celui-ci.

8. Procédé de fabrication d'un générateur thermoélectrique intégré à configuration de flux de chaleur hors plan, comprenant les étapes suivantes :
le dépôt d'une couche diélectrique (2) avec une épaisseur irrégulière sur une face d'un substrat de fond (1) afin de définir des collines et des vallées de matériau diélectrique,
le dépôt de segments juxtaposés (4, 5), dopés p et dopés n en alternance, de lignes de couches minces définies de segments d'un semi-conducteur polycristallin s'étendant sur des flancs opposés inclinés desdites collines,
le dépôt de contacts métalliques de jonction de sommet de colline (6) et de contacts métalliques de jonction de fond de vallée (7) joignant des extrémités juxtaposées desdits segments (4, 5) dopés p et dopés n en alternance,
le dépôt d'une couche de matériau sacrificiel (8) afin de remplir lesdites vallées et de recouvrir lesdits segments juxtaposés (4, 5), en laissant non recouvertes uniquement les surfaces supérieures desdits contacts métalliques de jonction de sommet de colline (6),
le dépôt d'une couche de recouvrement plane électriquement non conductrice (9) reposant sur lesdits contacts métalliques de jonction de sommet de colline,
**caractérisé en ce que** le procédé est entièrement compatible avec une technologie de fabrication de semi-conducteur à oxyde métallique complémentaire, CMOS, ou de BiCMOS frontaux, et comprend en outre les étapes de :
la réalisation de trous traversants suffisamment grands (10) pour laisser des solutions de gravure isotrope ou un plasma de gravure passer à travers ceux-ci, sur toute l'épaisseur de la couche de recouvrement électriquement non conductrice (9) ;
l'élimination dudit matériau sacrificiel (8) par l'injection d'une solution de gravure isotrope ou d'un plasma de gravure à travers lesdits trous traversants (10), afin d'amener la couche de recouvrement plane électriquement non conductrice (9) à reposer sur lesdits contacts métalliques de jonction de sommet de colline et à être suspendue au-dessus desdites vallées, toutes les vallées entre lesdites collines (3) étant des espaces vides délimités au sommet par la couche de recouvrement électriquement non conductrice (9), lesdits trous traversants (10) communiquant avec lesdits espaces vides ;
le dépôt d'une couche de coiffage supérieure (11) sur une surface libre, orientée dans une direction opposée par rapport auxdits espaces vides, de ladite couche de recouvrement plane électriquement non conductrice (9) de façon à obstruer les trous traversants (10) de la couche de recouvrement électriquement non conductrice (9).

9. Procédé selon la revendication 8, comprenant en outre les étapes de :
l'évacuation desdits espaces vides lors d'une encapsulation ;
le scellement permanent desdits espaces vides au cours de l'encapsulation ou d'opérations dorsales par l'obstruction d'intervalles latéraux entre le substrat de fond (1) et ladite couche de recouvrement électriquement non conductrice (9).
